# EUROPEAN PATENT SPECIFICATION

(11) **EP 4 372 806 B1**
(45) Date of publication and mention of the grant of the patent: **27.08.2025**
(21) Application number: 22315290.1
(22) Date of filing: 15.11.2022
(51) Int. Cl.: H01L 23/467, H01L 23/40, H01L 23/473, H01L 25/11

(54) **HEATSINK FOR COOLING ELECTRONIC DEVICE PACKAGES AND ASSOCIATED PACKAGING STACK**
KÜHLKÖRPER ZUR KÜHLUNG VON GEHÄUSEN ELEKTRONISCHER VORRICHTUNGEN UND ZUGEHÖRIGER VERPACKUNGSSTAPEL
DISSIPATEUR THERMIQUE POUR REFROIDIR DES BOÎTIERS DE DISPOSITIF ÉLECTRONIQUE ET EMPILEMENT DE BOÎTIERS ASSOCIÉ

(43) Date of publication of application: 22.05.2024
(73) Proprietor: GE Energy Power Conversion Technology Limited, Rugby, Warwickshire CV21 1BU (GB)
(72) Inventor: Clavier, Philippe, 91140 Villebon-sur-Yvette (FR); Baerd, Henri, 91140 Villebon-sur-Yvette (FR); Hamelin, Dimitri, 91140 Villebon-sur-Yvette (FR); Lenherr, Christian, 91140 Villebon-sur-Yvette (FR)
(74) Representative: Casalonga

(56) References cited:
- US-A- 3 280 389
- US-A- 3 736 474
- US-A1- 2010 038 058
- US-A1- 2013 050 947

## Description

The present invention concerns cooling of power electronics, and relates more particularly to a heatsink for cooling an electronic device package and a packaging stack comprising such heatsinks and electronic device packages.

Power converters for example for oil and gas applications, traction drives and high-power conversion equipment, for example rectifiers and inverters, typically include press-pack power devices.

A press-pack power device includes for example insulated gate bipolar transistors IGBTs.

Such a power converter further comprises heatsinks to dissipate the heat generated by the press-pack power devices. For example, US3280389A, US3736474A disclose heatsinks with two plates on both sides of a semiconductor plate. US2010/038058A1 discloses a presspack device with a cooling piece inside.

The press pack devices and the heatsinks are typically sandwiched to form a stack, the stack being compacted between two compaction plates to apply an homogeneous compaction pressure on the press-pack power devices.

Moreover, power signals delivered by the power converter flow through the press pack devices and the heatsinks generally made of an aluminium alloy.

A liquid cooled heatsink is generally made of one piece comprising a massive part sandwiched between two cooling parts comprising cooling channels.

Such a liquid cooled heatsink is disposed at each end of the stack so that a first surface of a cooling part is in contact with a press pack device and the second surface of the cooling part opposite to the first surface is in contact with a compaction plate.

As the temperature of the first and second surfaces are different, a temperature gradient is generated for the heatsinks at the ends of the stack.

These heatsinks are subjected to thermal expansion so that the heatsinks at the ends of the stack are deformed according to a "banana shape".

The deformation of the heatsinks generate excessive inhomogeneous stresses on the IGBTs in the center of press pack devices in the contact with the said heatsinks and causes a lack of pressure between the said heatsinks and the IGBTs at the edge of the press pack devices preventing an electrical contact between the said heatsinks and the IGBTs at the edge of the press pack devices.

Inhomogeneous stresses deteriorate some of the IGBTs and deteriorate the quality of the power supplied by the power converter and lead to failures of the power converter.

It is therefore proposed to remedy some of the disadvantage related to heatsinks according to the prior art.

In view of the foregoing the invention proposes a heatsink for cooling at least one electronic device package having an upper contact surface and a lower contact surface, the heat sink comprising a first cooling piece and a support piece comprising a first surface and a second surface opposite to the first surface, the first cooling piece comprising an inlet configured to receive a coolant and an outlet configured to exhaust the coolant, a first surface of the first cooling piece being configured to be in direct contact with one of the upper and lower contact surfaces, the first surface of the support piece being in direct contact with a second surface of the cooling piece.

The support piece and the first cooling piece are two independent pieces so that the interface between the first surface of the support piece and the second surface of the first cooling piece allows a relative movement between the support piece and the first cooling piece along a direction parallel to the interface between the first cooling piece and the support piece.

Advantageously, the heatsink further comprises a wedge having the same dimensions as the first cooling piece, the wedge being in direct contact with the second surface of the support piece.

Preferably, the wedge and the support piece are made in a single piece.

Preferably, the heatsink further comprises a second cooling piece comprising an inlet configured to receive the coolant and an outlet configured to exhaust the coolant, a first surface of the second cooling piece being configured to be in direct contact with one of the upper and lower contact surfaces of another second electronic device package, the second surface of the support piece being in direct contact with a second surface of the second cooling piece, the support piece and the second cooling piece are two independent pieces so that the interface between the second surface of the support piece and the second surface of the second cooling piece allows a relative movement between the support piece and the second cooling piece along a direction parallel to the interface between the second cooling piece and the support piece.

Advantageously, each cooling piece comprises a first side surface and a second side surface opposite to the first side surface, the first and second side surfaces extending between the first and the second surfaces of the said cooling piece, the inlet and the outlet of each cooling piece being disposed on a same side surface of the said cooling piece.

Preferably, the inlet and the outlet of the first and second cooling pieces are disposed on the same side surface of the heatsink comprising one of the first and second side surfaces of the first and second pieces, the side surface of the heatsink extending between the first surfaces of the first and second cooling pieces.

Advantageously, the inlet of each cooling piece comprising an inlet connecting part and the outlet of each cooling piece comprising an outlet connecting part, the support piece comprises two recesses on the surface in direct contact with the second surface of the said cooling piece, a first recess lodging with a clearance the inlet connecting part or the outlet connecting part and the second recess lodging with a clearance the outlet connecting part or the inlet connecting part.

Preferably, the inlet and the outlet of the first cooling piece are disposed on the second surface of the first cooling piece, the support piece comprising an inlet and an outlet disposed on a side face of the support piece extending between the first and second surfaces of the support, a first and a second apertures, and a first and a second channels, the first channel fluidly connecting the first aperture to the inlet of the support piece and the second channel fluidly connecting the second aperture to the outlet of the support piece, the first and second apertures being disposed on the first surface of the support piece so that the fluid flows from the inlet of the support piece to the inlet of the first cooling piece and flows from the outlet of the first cooling piece to the outlet of the support piece.

Advantageously, the inlet and the outlet of the second cooling piece are disposed on the second surface of the second cooling piece, the support piece further comprises a third and a fourth apertures, and a third and a fourth channels, the third channel fluidly connecting the third aperture to the inlet of the support piece and the fourth channel fluidly connecting the fourth aperture to the outlet of the support piece, the third and fourth apertures being disposed on the second surface of the support piece so that the fluid flows from the inlet of the support piece to the inlet of the second cooling piece and flows from the outlet of the second cooling piece to the outlet of the support piece.

Preferably, each aperture is surrounded by a groove, a gasket being inserted in the groove.

Advantageously, the heatsink further comprises centring means configured to assemble each cooling part on the support part.

Preferably, the centring means comprise a plurality of pins or holes disposed on the second surface of each cooling part and a plurality of holes or pins disposed on the surface of the support part in direct contact with the second surface of the said cooling part, each pin been inserted in a different hole with a clearance.

Another object of the invention relates to a packaging stack comprising at least two electronic device packages, each electronic device package comprising an upper and a lower contact surfaces, each upper surface and each lower surface of the electronic device packages being associated to one heatsink as defined above.

Advantageously, the electronic device packages and the heatsinks are compacted between two compaction plates.

Preferably, the packaging stack further comprises an inlet manifold and an outlet manifold, the inlet manifold being configured to supply the inlet of each cooling piece with coolant and the outlet manifold being configured to receive the cooling from the outlet of each cooling piece.

Advantageously, the inlet of a first or second cooling piece is connected to the inlet manifold, the outlet of the said first or second cooling piece is connected to the inlet of an adjacent first or second cooling piece to the said first or second cooling piece, the outlet of the adjacent first or second cooling piece is connected to the outlet manifold.

Other characteristics and advantages of the invention will emerge on reading the following description of embodiments of the invention, provided solely by way of non-limiting examples and with reference to the drawings in which:

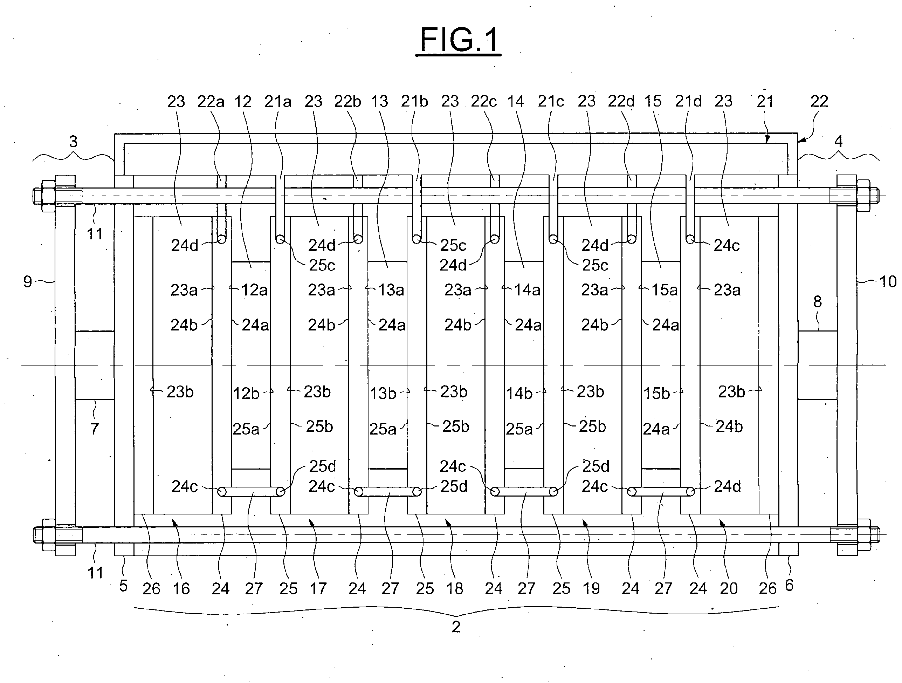

Figure 1 illustrates an example of a power converter according to the invention,
Figures 2 and 3 illustrate an example of a heatsink according to the invention,
Figure 4 illustrates another example of the heatsink according to the invention,
Figure 5 illustrates an example of a support piece according to the invention, and
Figure 6 illustrates an example of centring means according to the invention.

The power converter comprises a packaging stack 2 compacted between two compacting devices 3, 4.

Each compacting device 3, 4 comprises a compaction plate 5, 6, a pressure cone 7, 8, and a clamping plate 9, 10.

The pressure cone 7, 8 is sandwiched between the compaction plate 5, 6 and the clamping plate 9, 10.

A plurality of tie rods 11 connect the two clamping plates 9, 10 to maintain the packaging stack 2 compacted between the two compaction plates 5, 6.

The compacting devices 3, 4 may be done differently, for example the compacting devices 3, 4 may comprise the compaction plates 5, 6 and the pressure cones 7, 8, the pressure cones 7, 8 being connected by a clamping bar to maintain compacted the packaging stack 2 compacted between the two compaction plates 5, 6.

The packaging stack 2 comprises a plurality of electronic device packages 12, 13, 14, 15, a plurality of heatsinks 16, 17, 18, 19, 20, an inlet manifold 21, and an outlet manifold 22.

Each electronic device package 12, 13, 14, 15 may be cylindrical and comprises an upper contact surface 12a, 13a, 14a, 15a and a lower contact surface 12b, 13b, 14b, 15b.

Each electronic device packages 12, 13, 14, 15 may comprise a field effect transistor, for example an insulated gate bipolar transistor IGBT, integrated gate commutated thyristors IGCT or thyristors and gate turn-off thyristor GTO.

The packaging stack 2 further comprises cables (not represented) to connect the electronic device packages 12, 13, 14, 15 and control circuits (not represented) to control the electronic device packages 12, 13, 14, 15.

Each end of the packaging stack 2 is connected to a supply device (not represented), for example a grid, to supply the converter with a voltage, the voltage flowing through the electronic device packages 12, 13, 14, 15 and the heatsinks 16, 17, 18, 19, 20.

A first heatsink 16 is disposed between a first compaction plate 5 and a first electronic device packages 12, a second heatsink 17 is disposed between the first electronic device packages 12 and a second electronic device packages 13, a third heatsink 18 is disposed between the second electronic device packages 13 and a third electronic device packages 14, a fourth heatsink 19 is disposed between the third electronic device packages 14 and the fourth electronic device packages 15, and the fifth heatsink 20 is disposed between the fourth electronic device packages 15 and the second compaction plate 6.

An electrical insulating (not represented) is inserted between the first compaction plate 5 and the first heatsink 16, and the second compaction plate 6 and the fifth heatsink 20.

The first and fifth heatsinks 16, 20 have a same architecture, and the second, third and fourth heatsinks 17, 18, 19 are identical.

The packaging stack 2 may comprise more than four device packages and five heatsinks as represented, the heatsinks and the electronic device packages being alternately arranged, and the device packages at the end of the packaging stack 2 being separated from the compaction plates by a heatsink having the same architecture as the first and fifth heatsinks 16, 20.

Each heatsink 16, 17, 18, 19, 20 comprises a support piece 23 comprising a first surface 23a and a second surface 23b opposite to the first surface 23a, and a first cooling piece 24 comprising a first surface 24a and a second surface 24b opposite to the first surface 24a.

The first surface 24a of the first cooling piece 24 is in direct contact with one of the upper and lower contact surfaces 12a, 13a, 14a, 15a, 12b, 13b, 14b, 15b so that any element such as thermal grease is inserted between the first surface 24a and the upper contact surface or the lower contact surface.

The first surface 23a of each support piece 23 is in direct contact with the second surface 24b of the associated cooling piece 24 so that that any element such as thermal grease is inserted between the first surface 23a of each support piece 23 and the second surface 24b of the associated cooling piece 24.

The support piece 23 and the first cooling piece 24 are two independent pieces.

The support piece 23 and the first cooling piece 24 are stacked one on the other.

The interface between the first surface 23a of the support piece 23 and the second surface 24b of the first cooling piece 24 allows a relative movement between the support piece 23 and the first cooling piece 24 along a direction parallel to the interface between the first cooling piece 23 and the support piece 24.

As the support piece 23 can have a relative movement compared to the first cooling piece 24, under the thermal expansion of the support piece 23 resulting from a gradient temperature between the first and second surfaces of the support piece 23, the support piece 23 can move freely in the direction parallel to the interface without generating constraints on the electronic device package 12, 13, 14, 15.

As no constraints are generated by thermal expansion, the duration of the electronic device packages 12, 13, 14, 15 is extended and the electrical contact between the electronic device packages 12, 13, 14, 15 and the heatsinks 23 is enhanced.

The heatsinks may have a rectangular section or may have another shape, and are designed to cover at least the upper contact surface and the lower contact surface of the electronic device packages 12, 13, 14, 15.

It is assumed that the heatsinks have a rectangular section.

Each first cooling piece 24 comprises an inlet 24c receiving a coolant and an outlet 24d exhausting the coolant.

The inlet 24c is intended to be connected to the inlet manifold and the outlet 24d is intended to be connected to the outlet manifold.

The first cooling piece 24 comprises a cooling circuit connected to the inlet 24c and the outlet 24d.

The cooling circuit evacuates the thermal losses generated by the electronic device package 12, 13, 14, 15 in the coolant.

The coolant may comprise water or air.

Each second, third and fourth heatsinks 17, 18, 19 further comprises a second cooling piece 25 having the same architecture and the same dimensions as the first cooling piece 24.

The second cooling piece 25 comprises a first surface 25a, a second surface 25b, an inlet 25c receiving the coolant, and an outlet 25d exhausting the coolant.

The second cooling piece 25 further comprises the cooling circuit connected to the inlet 25c and outlet 25d.

The first surface 25a of the second cooling piece 25 is in direct contact with the lower surface 12b, 13b, 14b, 15b of the electronic device package 12, 13, 14, 15.

In variant, the first surface 25a of the second cooling piece 25 may be in direct contact with the upper surface 12a, 13a, 14a, 15a.

The second surface 23b of the support piece 23 is in direct contact with the second surface 25b of the second cooling piece 25.

The support piece 23 and the second cooling piece 25 are two independent pieces so that the interface between the second surface 23b of the support piece 23 and the second surface 25b of the second cooling piece 25 allows a relative movement between the support piece 23 and the second cooling piece 25 along a direction parallel to the interface between the second cooling piece 25 and the support piece 23.

Each of the first and fifth heatsinks 16, 20 further comprises a wedge 26 having the same dimensions as the first cooling piece 24.

The wedge 26 is sandwiched between the electrical insulating and the support piece 23 of the first and fifth heatsinks 16, 20, the wedge 26 being in direct contact with the second surface 23b of the support piece 23.

The first and fifth heatsinks 16, 20 comprising the wedges 26 have the same thickness as the second, third and fourth heatsinks 17, 18, 19.

The support pieces 23, the first cooling pieces 24, the second cooling pieces 25, and the wedges 26 are made of an electrically conductive material, for example an aluminium alloy.

In variant, the wedge 26 and the support piece 23 are made in a single piece permitting to ease the manufacturing of the packaging stack 2.

The thickness of the first and second cooling parts may be equal and may be one third of the thickness of the support part 23.

Each of the first and second rectangular cooling pieces 24, 25 comprises a first side surface and a second side surface opposite to the first side surface.

The first and second side surfaces of the first cooling piece 24 extend between the first and the second surfaces 24a, 24b.

The first and second side surfaces of the second cooling piece 25 extend between the first and the second surfaces 25a, 25b.

As represented, the inlet 24c and the outlet 24d of the first cooling pieces 24 are disposed on the same side surface of the first cooling pieces 24, and the inlet 25c and the outlet 25d of the second cooling pieces 25 are disposed on the same side surface of the second cooling pieces 25.

The localisation of the inlet and the outlet on the same side surface of a cooling piece simplify the connection of the inlet and the outlet to the inlet and outlet manifolds 21, 22.

In variant, the inlet 24c, 25c and the outlet 24d, 25d of the first and second cooling pieces 24, 25 may be disposed on different side surfaces.

Each heatsink 16, 17, 18, 19, 20 further comprises a first side surface and a second side surface extending between the first surfaces 24a, 25a of the first and second cooling pieces 24, 25.

Further, as represented, the inlet 24c, 25c and the outlet 24d, 25d of the first and second cooling pieces 24, 25 are disposed on the same side surface of the heatsinks 16, 17, 18, 19, 20 to simplify even more the connection of the inlet and the outlet to the inlet and outlet manifolds 21, 22.

In variant, the inlet 24c, 25c and outlet 24d, 25d of the first and second cooling pieces 24, 25 are disposed on different side surfaces of the heatsinks 16, 17, 18, 19, 20.

An inlet 24c, 25c of a first or second cooling piece 24, 25 is connected to the inlet manifold for example through an input duct 21a, 21b, 21c, 21d.

The outlet 24d, 25d of the said first or second cooling piece 24, 25 is connected to the inlet 24c, 25c of an adjacent first or second cooling piece 24, 25 for example through an intermediary duct 27.

The outlet 24d, 25d of the adjacent first or second cooling piece 24, 25 is connected to the outlet manifold 22 for example through an output duct 22a, 22b, 22c, 22d.

Two adjacent cooling pieces are fluidly connected together in series reducing the number of input and output ducts to simplify even more the connection of the inlet 24c, 25c and the outlet 24d, 25d to the inlet and outlet manifolds 21, 22.

Two adjacent cooling pieces may be fluidly connected together in series even if the inlets and the outlets of the first and second cooling pieces 24, 25 are not disposed on the same side surface of the heatsinks 16, 17, 18, 19 and even if the inlet and outlet of each first and second cooling pieces 24, 25 are not disposed on the same side surface of the said cooling piece.

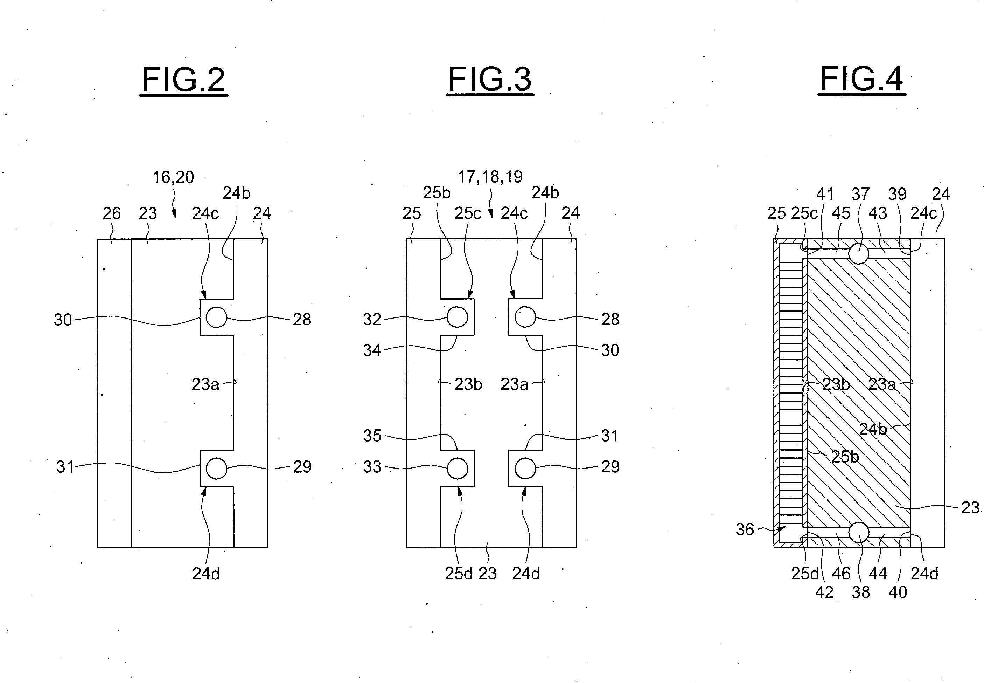

Figure 2 illustrates schematically a second example of the first and fifth heatsinks 16, 20 at the ends of the packaging stack 2 and figure 3 illustrates a second example of the second, third and fourth heatsinks 17, 18, 19 sandwiched between two electronic device packages 12, 13, 14, 15.

The second examples, the inlet 24c of the first cooling piece 24 comprises an inlet connecting part 28 and the outlet 24d of the first cooling piece 24 comprises an outlet connecting part 29.

The inlet connecting part 28 and the outlet connecting part 29 protrude from the first cooling piece 24.

In order to have a constant thickness of the heatsink, the support piece 23 comprises two recesses 30, 31 on the first surface 23a.

A first recess 30 lodges the inlet connecting part 28 with a clearance and the second recess 31 lodges the outlet connecting part 29 with clearance.

Equivalently, as illustrated on figure 3, the inlet 25c of the second cooling piece 25 comprises an inlet connecting part 32 and the outlet 25d of the second cooling piece 25 comprises an outlet connecting part 33, the inlet connecting part 32 and the outlet connecting part 33 protruding from the second cooling piece 25.

The support piece 23 comprises two recesses 34, 35 on the second surface 23b.

A first recess 34 lodges the inlet connecting part 32 with a clearance and the second recess 35 lodges the outlet connecting part 33 with a clearance.

The values of the clearances are determined so that a relative displacement between each cooling piece 24, 25 and the support piece 23 does not create an interference between the inlet and outlet connecting parts and the support piece to avoid constraints in the support part 23.

Figure 4 illustrates schematically a partial longitudinal section of a third example of the heatsinks 17, 18, 19 sandwiched between two electronic device packages 12, 13, 14, 15.

In this example, the inlet and outlet 24c, 24d of the first cooling piece 24 are disposed on the second surface 24b of the first cooling piece 24, and the inlet and outlet 25c, 25d of the second cooling piece 25 are disposed on the second surface 25b of the second cooling piece 25.

The inlet and outlet 25c, 25d of the second cooling part 25 are connected to the cooling circuit 36 having for example a spiral shape.

The support piece 23 comprises an inlet 37 connected to the input duct 21a, 21b, 21c, 21d and an outlet 38 connected to the output duct 22a, 22b, 22c, 22d, the inlet 37 and outlet 38 been disposed on a side surface of the support part 23.

The support piece 23 further comprises a first aperture 39 and a second aperture 40 disposed on the first surface 23a, and a third aperture 41 and a fourth aperture 42 disposed on the second surface 23b.

The support piece 23 comprises a first aperture 39 and a second aperture 40 disposed on the first surface 23a, and a third aperture 41 and a fourth aperture 42 disposed on the second surface 23b.

The support piece 23 further comprises a first channel 43, a second channel 44, a third channel 45 and a fourth channel 46.

The first channel 43 fluidly connects the inlet 37 to the first aperture 39, the second channel 44 fluidly connects the outlet 38 to the second aperture 40, the third channel 45 fluidly connects the inlet 37 to the third aperture 41, the fourth channel 46 fluidly connects the outlet 38 to the fourth aperture 42.

The coolant flows from the inlet 37 of the support piece 23 to the inlets 24c, 25c of the first and second cooling parts 24, 25, and exhausts the first and second cooling parts 24, 25 through the outlets 24d, 25d of the first and second cooling parts 24, 25 and the outlet 38 of the support part 23.

In this example, the intermediary ducts are suppressed simplifying the coolant circulation in the packaging stack 2.

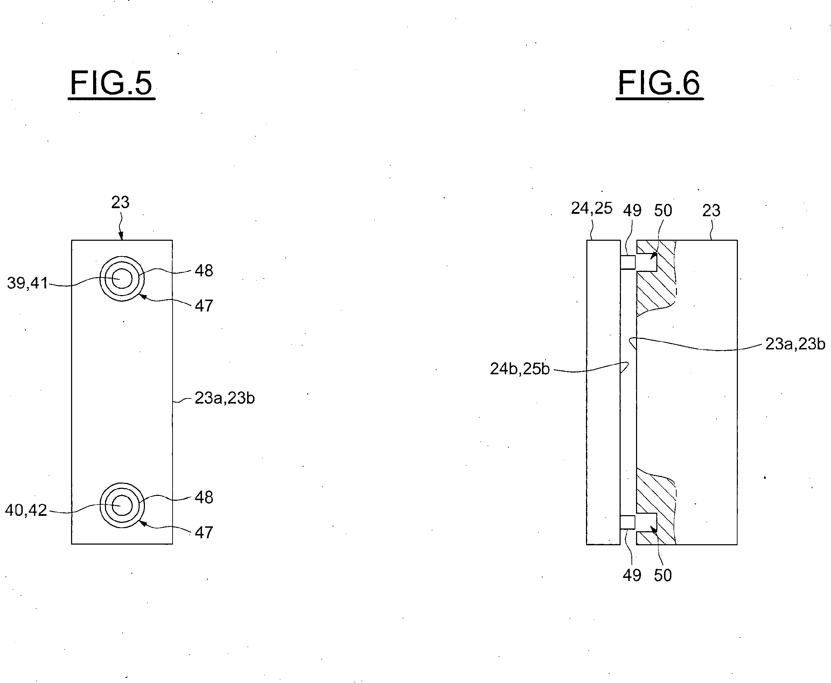

The first, second, third, and fourth apertures 39, 40, 41, 42 of the support piece 23 may be surrounded by a groove 47 and a gasket 48 inserted in the groove 47 as illustrated on figure 5.

The groove 47 and a gasket 48 inserted in the groove 47 enhance the sealing between the support party 23 and the first and second cooling parts 24, 25.

If the heatsink comprises only the first cooling part 24, the support part 23 may not comprise the third and fourth apertures 41, 42 and the third and fourth channels 45, 46.

In variant, the support part 23 comprises the third and fourth apertures 41, 42 and the third and fourth channels 45, 46, and further comprises plugs to obstruct the third and fourth apertures 41, 42.

The disclosed examples of heatsinks 16, 17, 18, 19, 20 may further comprise centring means to assemble the first and second cooling parts 24, 25 on the support piece 23.

Figure 6 illustrates schematically an example of the centring means.

The centring means may comprise a plurality of pins 49 disposed on the second surface 24b, 25b of the cooling part 24, 25 and a plurality of holes 50 disposed on the corresponding surface 23a, 23b of the support piece 23.

Each pin 49 is inserted in a different hole 50 with a clearance.

The value of the clearance is determined so a relative displacement between each cooling piece 24, 25 and the support piece 23 does not create an interference between the inlet and outlet connecting parts and the support piece to avoid constraints in the support part 23.

In variant, the plurality of holes 50 are disposed on the second surface 24b, 25b of the cooling part 24, 25 and the plurality of pins 49 are disposed on the corresponding surface 23a, 23b of the support piece 23.

## Claims

1. Heatsink (16, 17, 18, 19, 20) for cooling at least one electronic device package (12, 13, 14, 15) having an upper contact surface (12a, 13a, 14a, 15a) and a lower contact surface (12b, 13b, 14b, 15b), the heat sink comprising a first cooling piece (24) and a support piece (23) comprising a first surface (23a) and a second surface (23b) opposite to the first surface, the first cooling piece (24) comprising an inlet (24c) configured to receive a coolant and an outlet (24d) configured to exhaust the coolant, a first surface (24a) of the first cooling piece being configured to be in direct contact with one of the upper and lower contact surfaces, the first surface (23a) of the support piece (23) being in direct contact with a second surface (24b) of the cooling piece, **characterized in that** the support piece (23) and the first cooling piece (24) are two independent pieces so that the interface between the first surface of the support piece and the second surface of the first cooling piece allows a relative movement between the support piece and the first cooling piece along a direction parallel to the interface between the first cooling piece and the support piece.

2. Heatsink according to claim 1, further comprising a wedge (26) having the same dimensions as the first cooling piece (24), the wedge being in direct contact with the second surface (23b) of the support piece (23).

3. Heatsink according to claim 2, wherein the wedge (26) and the support piece (23) are made in a single piece.

4. Heatsink according to claim 1, further comprising a second cooling piece (25) comprising an inlet (25c) configured to receive the coolant and an outlet (25d) configured to exhaust the coolant, a first surface (25a) of the second cooling piece being configured to be in direct contact with one of the upper and lower contact surfaces of another second electronic device package (12, 13, 14, 15), the second surface (23b) of the support piece (23) being in direct contact with a second surface of the second cooling piece, the support piece and the second cooling piece are two independent pieces so that the interface between the second surface of the support piece and the second surface of the second cooling piece allows a relative movement between the support piece and the second cooling piece along a direction parallel to the interface between the second cooling piece and the support piece.

5. Heatsink according to any one of claims 1 to 4, wherein each cooling piece (24, 25) comprises a first side surface and a second side surface opposite to the first side surface, the first and second side surfaces extending between the first and the second surfaces of the said cooling piece, the inlet (24c, 25c) and the outlet (24d, 25d) of each cooling piece being disposed on a same side surface of the said cooling-piece.

6. Heatsink according to claim 5 depending on claim 4, wherein the inlet (24c, 25c) and the outlet (24d, 25d) of the first and second cooling pieces (24, 25) are disposed on the same side surface of the heatsink comprising one of the first and second side surfaces of the first and second pieces, the side surface of the heatsink extending between the first surfaces of the first and second cooling pieces.

7. Heatsink according to any one of claims 1 to 6, wherein the inlet (24c, 25c) of each cooling piece (24, 25) comprising an inlet connecting part (28, 32) and the outlet (24d, 25d) of each cooling piece comprising an outlet connecting part (29, 33), the support piece comprises two recesses (30, 31, 34, 35) on the surface (23a, 23b) in direct contact with the second surface (24b, 25b) of the said cooling piece, a first recess (30, 34) lodging with a clearance the inlet connecting part (28, 32) or the outlet connecting part (29, 33) and the second recess (31, 35) lodging with a clearance the outlet connecting part or the inlet connecting part.

8. Heatsink according to any one of claims 1 to 3, wherein the inlet (24c) and the outlet (24d) of the first cooling piece (24) are disposed on the second surface (24b) of the first cooling piece, the support piece (23) comprising an inlet (37) and an outlet (38) disposed on a side face of the support piece extending between the first and second surfaces (23a, 23b) of the support, a first and a second apertures (39, 40), and a first and a second channels (43, 44), the first channel fluidly connecting the first aperture to the inlet of the support piece and the second channel fluidly connecting the second aperture to the outlet of the support piece, the first and second apertures being disposed on the first surface of the support piece so that the fluid flows from the inlet of the support piece to the inlet of the first cooling piece and flows from the outlet of the first cooling piece to the outlet of the support piece.

9. Heatsink according to claim 8 depending on claim 4, wherein the inlet (25c) and the outlet (25d) of the second cooling piece (25) are disposed on the second surface (25b) of the second cooling piece, the support piece (23) further comprises a third and a fourth apertures (41, 42), and a third and a fourth channels (45, 46), the third channel fluidly connecting the third aperture to the inlet of the support piece and the fourth channel fluidly connecting the fourth aperture to the outlet of the support piece, the third and fourth apertures being disposed on the second surface of the support piece so that the fluid flows from the inlet of the support piece to the inlet of the second cooling piece and flows from the outlet of the second cooling piece to the outlet of the support piece.

10. Heatsink according to claim 8 or 9, wherein each aperture (39, 40, 41, 42) is surrounded by a groove (47), a gasket (48) being inserted in the groove.

11. Heatsink according to any one of claims 1 to 10, further comprising centring means configured to assemble each cooling part (24, 25) on the support part (23).

12. Heatsink according to claim 11, wherein the centring means comprise a plurality of pins (49) or holes (50) disposed on the second surface (24b, 25b) of each cooling part (24, 25) and a plurality of holes (50) or pins (49) disposed on the surface (23a, 23b) of the support part (23) in direct contact with the second surface of the said cooling part, each pin been inserted in a different hole with a clearance.

13. Packaging stack (2) comprising at least two electronic device packages (12, 13, 14, 15), each electronic device package comprising an upper and a lower contact surfaces (12a, 13a, 14a, 15a, 12b, 13b, 14b, 15b), each upper surface and each lower surface of the electronic device packages being associated to one heatsink (16, 17,-18, 19, 20) according to any one of claims 1 to 12.

14. Packaging stack according to claim 13, further comprising an inlet manifold (21) and an outlet manifold (22), the inlet manifold being configured to supply the inlet (24c, 25c) of each cooling piece (24, 25) with coolant and the outlet manifold being configured to receive the cooling from the outlet (24d, 25d) of each cooling piece.

15. Packaging stack according to claim 14, wherein the inlet (24c, 25c) of a first or second cooling piece is connected to the inlet manifold (21), the outlet (24d, 25d) of the said first or second cooling piece is connected to the inlet of an adjacent first or second cooling piece to the said first or second cooling piece, the outlet of the adjacent first or second cooling piece is connected to the outlet manifold (22).

## Patentansprüche

1. Kühlkörper (16, 17, 18, 19, 20) zur Kühlung mindestens einer elektronischen Geräteverpackung (12, 13, 14, 15) mit einer oberen Kontaktfläche (12a, 13a, 14a, 15a) und einer unteren Kontaktfläche (12b, 13b, 14b, 15b), wobei der Kühlkörper ein erstes Kühlbauteil (24) und ein Stützbauteil (23) umfasst, das eine erste Oberfläche (23a) und eine zweite der ersten Oberfläche gegenüberliegende Oberfläche (23b) umfasst, wobei das erste Kühlbauteil (24) einen Einlass (24c), der so eingerichtet ist, dass er ein Kühlmittel aufnimmt, und einen Auslass (24d) umfasst, der so eingerichtet ist, dass er das Kühlmittel abführt, wobei eine erste Oberfläche (24a) des ersten Kühlbauteils so eingerichtet ist, dass sie in direktem Kontakt mit einer von der oberen und der unteren Kontaktfläche steht, wobei die erste Oberfläche (23a) des Stützbauteils (23) in direktem Kontakt mit einer zweiten Oberfläche (24b) des Kühlbauteils steht, **dadurch gekennzeichnet, dass** das Stützbauteil (23) und das erste Kühlbauteil (24) zwei unabhängige Bauteile sind, so dass die Schnittstelle zwischen der ersten Oberfläche des Stützbauteils und der zweiten Oberfläche des ersten Kühlbauteils eine relative Bewegung zwischen dem Stützbauteil und dem ersten Kühlbauteil entlang einer Richtung parallel zur Schnittstelle zwischen dem ersten Kühlbauteil und dem Stützbauteil ermöglicht.

2. Kühlkörper nach Anspruch 1, ferner umfassend einen Keil (26) mit denselben Abmessungen wie das erste Kühlbauteil (24), wobei der Keil in direktem Kontakt mit der zweiten Oberfläche (23b) des Stützbauteils (23) steht.

3. Kühlkörper nach Anspruch 2, wobei der Keil (26) und das Stützbauteil (23) aus einem Stück gefertigt sind.

4. Kühlkörper nach Anspruch 1, ferner umfassend ein zweites Kühlbauteil (25), das einen Einlass (25c), der so eingerichtet ist, dass er das Kühlmittel aufnimmt, und einen Auslass (25d) umfasst, der so eingerichtet ist, dass er das Kühlmittel abführt, wobei eine erste Oberfläche (25a) des zweiten Kühlbauteils so eingerichtet ist, dass sie in direktem Kontakt mit einer von der oberen und der unteren Kontaktfläche einer weiteren zweiten elektronischen Geräteverpackung (12, 13, 14, 15) steht, wobei die zweite Oberfläche (23b) des Stützbauteils (23) in direktem Kontakt mit einer zweiten Oberfläche des zweiten Kühlbauteils steht, wobei das Stützbauteil und das zweite Kühlbauteil zwei unabhängige Bauteile sind, so dass die Schnittstelle zwischen der zweiten Oberfläche des Stützbauteils und der zweiten Oberfläche des zweiten Kühlbauteils eine relative Bewegung zwischen dem Stützbauteil und dem zweiten Kühlbauteil entlang einer Richtung parallel zur Schnittstelle zwischen dem zweiten Kühlbauteil und dem Stützbauteil ermöglicht.

5. Kühlkörper nach einem der Ansprüche 1 bis 4, wobei jedes Kühlbauteil (24, 25) eine erste Seitenfläche und eine zweite der ersten Seitenfläche gegenüberliegende Seitenfläche umfasst, wobei sich die erste und die zweite Seitenfläche zwischen der ersten und der zweiten Oberfläche des Kühlbauteils erstrecken, wobei der Einlass (24c, 25c) und der Auslass (24d, 25d) jedes Kühlbauteils auf derselben Seitenfläche des Kühlbauteils angeordnet sind.

6. Kühlkörper nach Anspruch 5, in Abhängigkeit von Anspruch 4, wobei der Einlass (24c, 25c) und der Auslass (24d, 25d) des ersten und des zweiten Kühlbauteils (24, 25) auf derselben Seitenfläche des Kühlkörpers angeordnet sind, die eine von der ersten und der zweiten Seitenfläche des ersten und des zweiten Bauteils umfasst, wobei sich die Seitenfläche des Kühlkörpers zwischen den ersten Oberflächen des ersten und des zweiten Kühlbauteils erstreckt.

7. Kühlkörper nach einem der Ansprüche 1 bis 6, wobei der Einlass (24c, 25c) jedes Kühlbauteils (24, 25) ein Einlassverbindungsteil (28, 32) umfasst und der Auslass (24d, 25d) jedes Kühlbauteils ein Auslassverbindungsteil (29, 33) umfasst, wobei das Stützbauteil zwei Aussparungen (30, 31, 34, 35) an der Oberfläche (23a, 23b) in direktem Kontakt mit der zweiten Oberfläche (24b), 25b) des Kühlbauteils umfasst, wobei eine erste Aussparung (30, 34) das Einlassverbindungsteil (28, 32) oder das Auslassverbindungsteil (29, 33) mit Spiel aufnimmt und die zweite Aussparung (31, 35) das Auslassverbindungsteil oder das Einlassverbindungsteil mit Spiel aufnimmt.

8. Kühlkörper nach einem der Ansprüche 1 bis 3, wobei der Einlass (24c) und der Auslass (24d) des ersten Kühlbauteils (24) auf der zweiten Oberfläche (24b) des ersten Kühlbauteils angeordnet sind, wobei das Stützbauteil (23) einen Einlass (37) und einen Auslass (38), die auf einer Seitenfläche des Stützbauteils angeordnet sind, die sich zwischen der ersten und der zweiten Oberfläche (23a, 23b) der Stütze erstreckt, eine erste und eine zweite Öffnung (39, 40) und einen ersten und einen zweiten Kanal (43, 44) umfasst, wobei der erste Kanal die erste Öffnung fluidisch mit dem Einlass des Stützbauteils verbindet und der zweite Kanal die zweite Öffnung fluidisch mit dem Auslass des Stützbauteils verbindet, wobei die erste und die zweite Öffnung auf der ersten Oberfläche des Stützbauteils angeordnet sind, so dass das Fluid von dem Einlass des Stützbauteils zu dem Einlass des ersten Kühlbauteils fließt und von dem Auslass des ersten Kühlbauteils zu dem Auslass des Stützbauteils fließt.

9. Kühlkörper nach Anspruch 8, in Abhängigkeit von Anspruch 4, wobei der Einlass (25c) und der Auslass (25d) des zweiten Kühlbauteils (25) auf der zweiten Oberfläche (25b) des zweiten Kühlbauteils angeordnet sind, wobei das Stützbauteil (23) ferner eine dritte und eine vierte Öffnung (41, 42) und einen dritten und einen vierten Kanal (45, 46) umfasst, wobei der dritte Kanal die dritte Öffnung fluidisch mit dem Einlass des Stützbauteils verbindet und der vierte Kanal die vierte Öffnung fluidisch mit dem Auslass des Stützbauteils verbindet, wobei die dritte und die vierte Öffnung auf der zweiten Oberfläche des Stützbauteils angeordnet sind, so dass das Fluid von dem Einlass des Stützbauteils zu dem Einlass des zweiten Kühlbauteils fließt und von dem Auslass des zweiten Kühlbauteils zu dem Auslass des Stützbauteils fließt.

10. Kühlkörper nach Anspruch 8 oder 9, wobei jede Öffnung (39, 40, 41, 42) von einer Nut (47) umgeben ist, wobei eine Dichtung (48) in die Nut eingesetzt ist.

11. Kühlkörper nach einem der Ansprüche 1 bis 10, ferner umfassend Zentriermittel, die so eingerichtet sind, dass sie jedes Kühlbauteil (24, 25) an dem Stützbauteil (23) montieren.

12. Kühlkörper nach Anspruch 11, wobei die Zentriermittel eine Vielzahl von Stiften (49) oder Löchern (50), die auf der zweiten Oberfläche (24b, 25b) jedes Kühlbauteils (24, 25) angeordnet sind, und eine Vielzahl von Löchern (50) oder Stiften (49) umfassen, die auf der Oberfläche (23a, 23b) des Stützbauteils (23) in direktem Kontakt mit der zweiten Oberfläche des Kühlbauteils angeordnet sind, wobei jeder Stift in ein anderes Loch mit Spiel eingesetzt ist.

13. Verpackungsstapel (2), umfassend mindestens zwei elektronische Geräteverpackungen (12, 13, 14, 15), wobei jede elektronische Geräteverpackung eine obere und eine untere Kontaktfläche (12a, 13a, 14a, 15a, 12b, 13b, 14b, 15b) umfasst, wobei jede obere Oberfläche und jede untere Oberfläche der elektronischen Geräteverpackung mit einem Kühlkörper (16, 17, 18, 19, 20) nach einem der Ansprüche 1 bis 12 verbunden ist.

14. Verpackungsstapel nach Anspruch 13, ferner umfassend einen Einlasskrümmer (21) und einen Auslasskrümmer (22), wobei der Einlasskrümmer so eingerichtet ist, dass er den Einlass (24c, 25c) jedes Kühlbauteils (24, 25) mit Kühlmittel versorgt, und der Auslasskrümmer so eingerichtet ist, dass er die Kühlung von dem Auslass (24d, 25d) jedes Kühlbauteils aufnimmt.

15. Verpackungsstapel nach Anspruch 14, wobei der Einlass (24c, 25c) eines ersten oder zweiten Kühlbauteils mit dem Einlasskrümmer (21) verbunden ist, der Auslass (24d, 25d) des ersten oder zweiten Kühlbauteils mit dem Einlass eines dem ersten oder zweiten Kühlbauteil benachbarten ersten oder zweiten Kühlbauteils verbunden ist, der Auslass des benachbarten ersten oder zweiten Kühlbauteils mit dem Auslasskrümmer (22) verbunden ist.

## Revendications

1. Dissipateur thermique (16, 17, 18, 19, 20) pour refroidir au moins un boîtier de dispositifs électroniques (12, 13, 14, 15) présentant une surface de contact supérieure (12a), 13a, 14a, 15a) et une surface de contact inférieure (12b, 13b, 14b, 15b), le dissipateur thermique comprenant une première pièce de refroidissement (24) et une pièce de support (23) comprenant une première surface (23a) et une seconde surface (23b) opposée à la première surface, la première pièce de refroidissement (24) comprenant une entrée (24c) configurée pour recevoir un liquide de refroidissement et une sortie (24d) configurée pour évacuer le liquide de refroidissement, une première surface (24a) de la première pièce de refroidissement étant configurée pour être en contact direct avec l'une des surfaces de contact supérieure et inférieure, la première surface (23a) de la pièce de support (23) étant en contact direct avec une seconde surface (24b) de la pièce de refroidissement, **caractérisé en ce que** la pièce de support (23) et la première pièce de refroidissement (24) sont deux pièces indépendantes de sorte que l'interface entre la première surface de la pièce de support et la seconde surface de la première pièce de refroidissement permette un mouvement relatif entre la pièce de support et la première pièce de refroidissement le long d'une direction parallèle à l'interface entre la première pièce de refroidissement et la pièce de support.

2. Dissipateur thermique selon la revendication 1, comprenant en outre une cale (26) présentant les mêmes dimensions que la première pièce de refroidissement (24), la cale étant en contact direct avec la seconde surface (23b) de la pièce de support (23).

3. Dissipateur thermique selon la revendication 2, dans lequel la cale (26) et la pièce de support (23) sont réalisées en une seule pièce.

4. Dissipateur thermique selon la revendication 1, comprenant en outre une seconde pièce de refroidissement (25) comprenant une entrée (25c) configurée pour recevoir le liquide de refroidissement et une sortie (25d) configurée pour évacuer le liquide de refroidissement, une première surface (25a) de la seconde pièce de refroidissement étant configurée pour être en contact direct avec l'une des surfaces de contact supérieure et inférieure d'un autre deuxième boîtier de dispositifs électroniques (12, 13, 14, 15), la seconde surface (23b) de la pièce de support (23) étant en contact direct avec une seconde surface de la seconde pièce de refroidissement, la pièce de support et la seconde pièce de refroidissement sont deux pièces indépendantes de sorte que l'interface entre la seconde surface de la pièce de support et la seconde surface de la seconde pièce de refroidissement permette un mouvement relatif entre la pièce de support et la seconde pièce de refroidissement le long d'une direction parallèle à l'interface entre la seconde pièce de refroidissement et la pièce de support.

5. Dissipateur thermique selon l'une quelconque des revendications 1 à 4, dans lequel chaque pièce de refroidissement (24, 25) comprend une première surface latérale et une seconde surface latérale opposée à la première surface latérale, les première et seconde surfaces latérales s'étendant entre les première et seconde surfaces de ladite pièce de refroidissement, l'entrée (24c, 25c) et la sortie (24d, 25d) de chaque pièce de refroidissement étant disposées sur une même surface latérale de ladite pièce de refroidissement.

6. Dissipateur thermique selon la revendication 5 dépendant de la revendication 4, dans lequel l'entrée (24c, 25c) et la sortie (24d, 25d) des première et seconde pièces de refroidissement (24, 25) sont disposées sur la même surface latérale du dissipateur thermique comprenant l'une des première et seconde surfaces latérales des première et seconde pièces, la surface latérale du dissipateur thermique s'étendant entre les premières surfaces des première et seconde pièces de refroidissement.

7. Dissipateur thermique selon l'une quelconque des revendications 1 à 6, dans lequel l'entrée (24c, 25c) de chaque pièce de refroidissement (24, 25) comprend une pièce de raccordement d'entrée (28, 32) et la sortie (24d, 25d) de chaque pièce de refroidissement comprend une pièce de raccordement de sortie (29, 33), la pièce de support comprend deux évidements (30, 31, 34, 35) sur la surface (23a, 23b) en contact direct avec la seconde surface (24b, 25b) de ladite pièce de refroidissement, un premier évidement (30, 34) logeant avec un dégagement la pièce de raccordement d'entrée (28, 32) ou la pièce de raccordement de sortie (29, 33) et le second évidement (31, 35) logeant avec un dégagement la pièce de raccordement de sortie ou la pièce de raccordement d'entrée.

8. Dissipateur thermique selon l'une quelconque des revendications 1 à 3, dans lequel l'entrée (24c) et la sortie (24d) de la première pièce de refroidissement (24) sont disposées sur la seconde surface (24b) de la première pièce de refroidissement, la pièce de support (23) comprenant une entrée (37) et une sortie (38) disposées sur une face latérale de la pièce de support s'étendant entre les première et seconde surfaces (23a, 23b) du support, une première et une deuxième ouvertures (39, 40), et un premier et un deuxième canaux (43, 44), le premier canal reliant fluidiquement la première ouverture à l'entrée de la pièce de support et le deuxième canal reliant fluidiquement la deuxième ouverture à la sortie de la pièce de support, les première et deuxième ouvertures étant disposées sur la première surface de la pièce de support de sorte que le fluide s'écoule de l'entrée de la pièce de support à l'entrée de la première pièce de refroidissement et s'écoule de la sortie de la première pièce de refroidissement à la sortie de la pièce de support.

9. Dissipateur thermique selon la revendication 8 dépendant de la revendication 4, dans lequel l'entrée (25c) et la sortie (25d) de la seconde pièce de refroidissement (25) sont disposées sur la seconde surface (25b) de la seconde pièce de refroidissement, la pièce de support (23) comprend en outre une troisième et une quatrième ouvertures (41, 42), et un troisième et un quatrième canaux (45, 46), le troisième canal reliant fluidiquement la troisième ouverture à l'entrée de la pièce de support et le quatrième canal reliant fluidiquement la quatrième ouverture à la sortie de la pièce de support, les troisième et quatrième ouvertures étant disposées sur la seconde surface de la pièce de support de sorte que le fluide s'écoule de l'entrée de la pièce de support à l'entrée de la seconde pièce de refroidissement et s'écoule de la sortie de la seconde pièce de refroidissement à la sortie de la pièce de support.

10. Dissipateur thermique selon la revendication 8 ou 9, dans lequel chaque ouverture (39, 40, 41, 42) est entourée d'une rainure (47), un joint (48) étant inséré dans la rainure.

11. Dissipateur thermique selon l'une quelconque des revendications 1 à 10, comprenant en outre des moyens de centrage configurés pour assembler chaque pièce de refroidissement (24, 25) sur la pièce de support (23).

12. Dissipateur thermique selon la revendication 11, dans lequel les moyens de centrage comprennent une pluralité de goupilles (49) ou de trous (50) disposés sur la seconde surface (24b, 25b) de chaque pièce de refroidissement (24, 25) et une pluralité de trous (50) ou de goupilles (49) disposés sur la surface (23a, 23b) de la pièce de support (23) en contact direct avec la seconde surface de ladite pièce de refroidissement, chaque goupille étant insérée dans un trou différent avec un dégagement.

13. Empilement de boîtiers (2) comprenant au moins deux boîtiers de dispositifs électroniques (12, 13, 14, 15), chaque boîtier de dispositifs électroniques comprenant des surfaces de contact supérieure et inférieure (12a, 13a, 14a, 15a), 12b, 13b, 14b, 15b), chaque surface supérieure et chaque surface inférieure des boîtiers de dispositifs électroniques étant associées à un dissipateur de chaleur (16, 17, 18, 19, 20) selon l'une quelconque des revendications 1 à 12.

14. Empilement de boîtiers selon la revendication 13, comprenant en outre un collecteur d'entrée (21) et un collecteur de sortie (22), le collecteur d'entrée étant configuré pour alimenter l'entrée (24c, 25c) de chaque pièce de refroidissement (24, 25) en liquide de refroidissement et le collecteur de sortie étant configuré pour recevoir le refroidissement de la sortie (24d, 25d) de chaque pièce de refroidissement.

15. Empilement de boîtiers selon la revendication 14, dans lequel l'entrée (24c, 25c) d'une première ou seconde pièce de refroidissement est reliée au collecteur d'entrée (21), la sortie (24d, 25d) de ladite première ou seconde pièce de refroidissement est reliée à l'entrée d'une première ou seconde pièce de refroidissement adjacente à ladite première ou seconde pièce de refroidissement, la sortie de la première ou seconde pièce de refroidissement adjacente est reliée au collecteur de sortie (22).
